# FASCICULE DE BREVET EUROPEEN

(11) **EP 0 542 647 B1**
(45) Date de publication et mention de la délivrance du brevet: **23.04.1997**
(21) Numéro de dépôt: 92420405.0
(22) Date de dépôt: 09.11.1992
(51) Int. Cl.: H01L 21/308

(54) **Procédé de gravure d'un sillon profond**
Verfahren zur Ätzung eines tiefen Grabens
Process for etching a deep trench

(30) Priorité: 14.11.1991 FR 9114366
(43) Date de publication de la demande: 19.05.1993
(73) Titulaire: SGS-THOMSON MICROELECTRONICS S.A., 94250 Gentilly (FR)
(72) Inventeur: Ducreux, Gérard, F-37230 Luynes (FR)
(74) Mandataire: de Beaumont, Michel

(56) Documents cités:
- DE-A- 2 024 608
- DE-B- 1 297 951
- US-A- 3 980 508
- IBM TECHNICAL DISCLOSURE BULLETIN. vol. 14, no. 9, Février 1972, NEW YORK US page 2607 L.M. ELIJAH ET AL. 'ETCHING TECHNIQUE FOR MINIMUM UNDERCUTTING.'

## Description

La présente invention concerne le domaine de la fabrication des composants semiconducteurs et plus particulièrement des semiconducteurs de puissance comprenant des sillons profonds, par exemple des sillons latéraux destinés à couper une jonction en dessous de la surface du composant semiconducteur considéré pour former une structure dite "mesa".

On entend ici par sillon profond des sillons d'une profondeur de l'ordre de 50 à 150 micromètres.

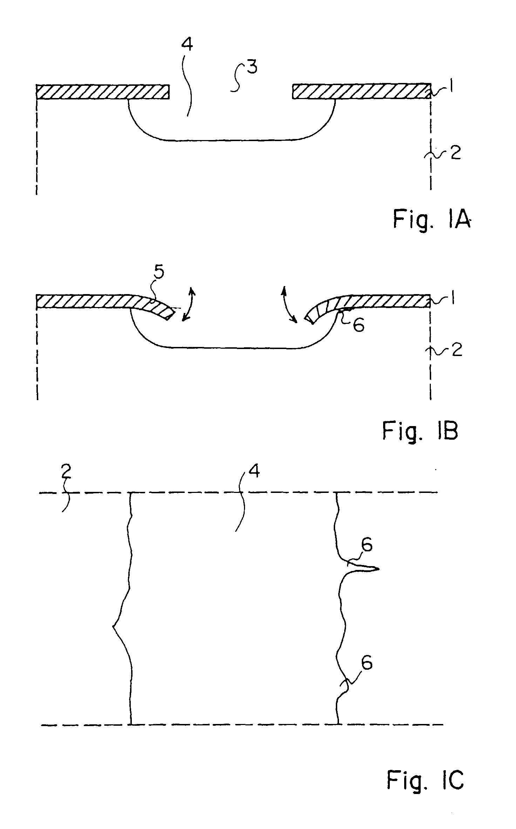

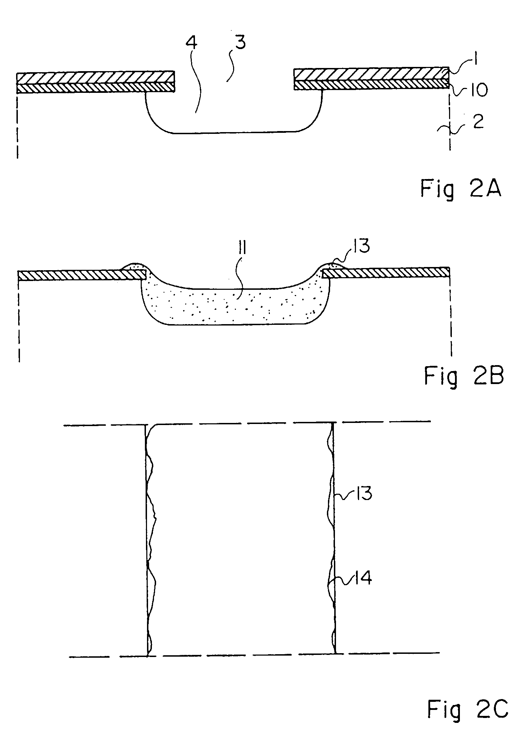

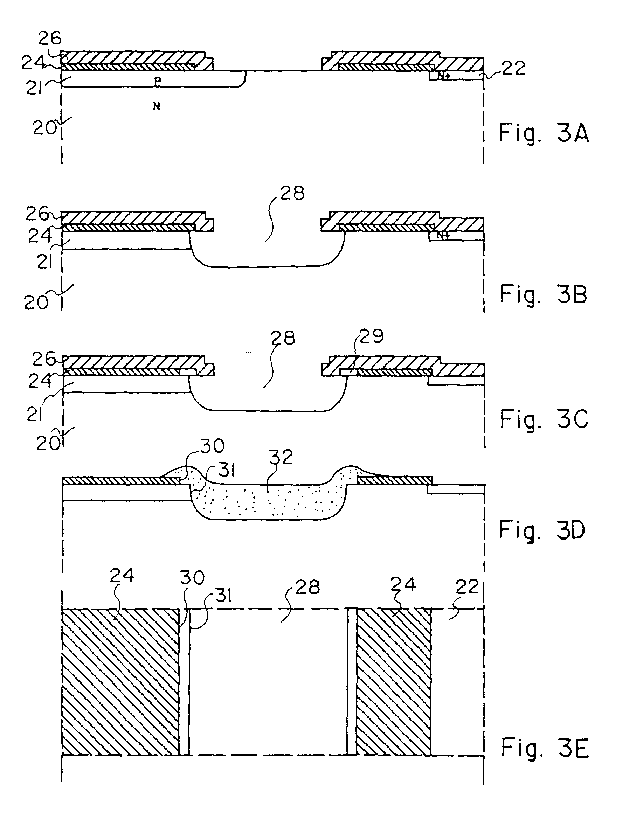

On va d'abord décrire en relation avec les figures 1A à 1C et 2A à 2C des techniques classiques de gravure de sillon pour faire ressortir les inconvénients de l'art antérieur et les problèmes posés.

La technique illustrée en figures 1A à 1C, utilise simplement un masque de résine 1 formé sur un substrat de silicium 2. Ce masque comprend une ouverture 3 qui sert à délimiter un sillon. Ensuite, la plaquette est plongée dans un bain de gravure de silicium, sélectif par rapport à la résine, et un sillon 4 se forme.

Cette solution très simple convient seulement à la gravure de sillons peu profonds, de moins de 50 micromètres car elle présente les inconvénients suivants :
- tout d'abord, dans le bain de gravure, ou bien le bain est agité ou bien la pièce est entraînée en vibration pour assurer une homogénéité du produit d'attaque. Dans ce cas, une fois que la gravure a commencé, les portions 5 (voir figure 1B) de la résine entrent en vibration et ceci contribue à provoquer un décollement de la résine par rapport au silicium sur lequel elle est posée ;
- en raison du décollement de la résine qui survient notamment pour la raison énoncée ci-dessus, du produit de gravure pénètre à l'interface entre la résine et le substrat de silicium et il en résulte des surgravures localisées du silicium sous la résine comme cela est désigné par la référence 6 dans la vue en coupe de la figure 1B et dans la vue de dessus de la figure 1C. Cette mauvaise définition des bords entraîne une mauvaise définition des qualités électriques du composant obtenu ;
- quand on a creusé un sillon, on souhaite souvent, après rinçage et contrôle, procéder à une opération supplémentaire d'attaque, dite de reprise ; dans le cas d'un masque de résine, il est pratiquement impossible d'effectuer une telle opération car, après le rinçage, la résine est encore plus décollée du substrat et le produit d'attaque pénétrerait à l'interface entre la résine et le substrat ce qui entraînerait une aggravation des défauts susmentionnés ;
- enfin, quand on procède avec un masque de résine, on s'aperçoit que l'étendue latérale de la gravure sous la résine est sensiblement égale à la profondeur de gravure verticale. En d'autres termes, le rapport entre les gravures latérale et verticale est sensiblement de 1/1.

Pour améliorer le résultat dans le cas de gravures profondes, on utilise donc de préférence actuellement le procédé illustré en figures 2A à 2C. Selon ce procédé, la couche de résine 1 est déposée au-dessus d'une couche d'oxyde de silicium 10, cette couche d'oxyde de silicium 10 étant ouverte après la couche de résine selon le masque déterminé par cette couche de résine. On obtient donc comme précédemment une ouverture 3 servant à former un sillon 4.

Ce procédé présente par rapport au précédent les avantages suivants. D'une part, la présence de la couche d'oxyde de silicium relativement rigide sous la couche de résine évite la mise en vibration des parties de résine et d'oxyde en surplomb et réduit donc les problèmes de décollement de résine. D'autre part, on s'aperçoit que, dans le cas où la gravure est effectuée sous une couche d'oxyde, le rapport entre gravures latérale et verticale est de l'ordre de 0,75 au lieu de 1. Le sillon est donc mieux défini. Enfin, il est possible de prolonger la gravure pour obtenir des sillons d'une profondeur allant jusqu'à quelques centaines de micromètres (par exemple 100 à 200 micromètres). Toutefois, ce procédé entraîne d'autres inconvénients :
- si l'oxyde de silicium est relativement rigide, il présente l'inconvénient d'être cassant et il est possible que des parties de la couche d'oxyde de silicium en surplomb se brisent pendant l'opération de gravure pour venir se déposer dans le sillon ce qui entraînera des défauts d'attaque ponctuels ;
- en fin de procédé, on enlève la couche de résine par un produit d'attaque sélectif puis on brise les parties d'oxyde en surplomb classiquement par des jets d'eau sous pression. Il risque toutefois de demeurer localement des casquettes d'oxyde 13, 14 (voir figures 2B et 2C) ;
- enfin, si l'on procède à un ravivage, c'est-à-dire à une attaque supplémentaire du sillon de silicium en fin de procédé, ceci entraînera l'apparition d'une nouvelle casquette d'oxyde de silicium. L'inconvénient de cette casquette est (comme cela est illustré en figure 2B) que, quand on dépose un produit de passivation, par exemple un verre 11 dans le sillon, l'épaisseur du verre sera réduite au voisinage de la casquette ce qui réduit la qualité de la protection et crée des zones où sont susceptibles d'apparaître des arcs électriques.

On notera en outre que dans ce procédé, à la fin de la gravure du sillon, l'adhérence entre la résine et l'oxyde de silicium n'est pas très bonne, étant donné que la résine a subi plusieurs agressions successives à savoir d'une part l'agression résultant de l'ouverture de la couche d'oxyde, et d'autre part l'agression correspondant à la gravure du sillon et aux rinçages intermédiaire et final. Ainsi, il n'est pas possible dans ce procédé d'attaquer la couche d'oxyde de silicium par un agent de gravure sélectif avant d'éliminer la couche de résine car alors le produit d'attaque de l'oxyde de silicium risquerait de pénétrer profondément entre les couches de résine et d'oxyde de silicium et de réduire au moins localement l'épaisseur de l'oxyde de silicium et d'aller polluer des zones sensibles éloignées du sillon.

La figure 2C représente une vue de dessus du sillon obtenu par le procédé des figures 2A et 2B. Les limites du sillon sont bien rectilignes, comme cela est indiqué par la ligne 13, mais il subsiste fréquemment des casquettes irrégulières d'oxyde 14 en surplomb qui peuvent conduire à des détériorations des qualités électriques du composant comme cela a été exposé précédemment.

Le document DE-B-1 297 951 décrit un procédé de gravure de sillon conforme au préambule de la revendication 1.

La présente invention vise à prévoir un nouveau procédé de formation de sillon profond palliant les inconvénients des procédés susmentionnés.

Pour atteindre cet objet, la présente invention prévoit un procédé de gravure d'un sillon profond dans un substrat de silicium consistant à délimiter un masque d'oxyde correspondant sensiblement à la forme du sillon désiré ; à enlever la résine ayant servi à former le masque d'oxyde ; à déposer une nouvelle couche de résine et à la graver pour définir un masque de résine chevauchant les bords du masque d'oxyde ; à immerger la plaquette dans un bain de gravure du silicium pour former le sillon désiré, ce sillon s'étendant partiellement sous le masque d'oxyde ; à rincer ; à immerger la plaquette dans un bain de gravure de l'oxyde de silicium pour éliminer la casquette d'oxyde surplombant le sillon et une partie de la couche d'oxyde s'étendant sur le substrat au-delà des limites du sillon ; et à éliminer la nouvelle couche de résine.

Selon un mode de réalisation de la présente invention, le masque de résine déborde d'environ 20 micromètres par rapport au masque d'oxyde.

Selon un mode de réalisation de la présente invention, l'étape de gravure du silicium est poursuivie jusqu'à ce que le sillon ait une profondeur de l'ordre de 50 à 150 micromètres.

Selon un mode de réalisation de la présente invention, l'étape de gravure de l'oxyde de silicium est poursuivie jusqu'à ce que l'oxyde de silicium soit en retrait du sillon d'environ 10 micromètres.

Ces objets, caractéristiques et avantages ainsi que d'autres de la présente invention seront exposés en détail dans la description suivante de modes de réalisation particuliers faite en relation avec les figures jointes parmi lesquelles :
les figures 1A et 1B représentent des vues en coupe illustrant un premier procédé classique de réalisation de sillon et la figure 1C représente une vue de dessus correspondante ;
les figures 2A et 2B illustrent des vues en coupe illustrant un deuxième procédé classique de réalisation de sillon et la figure 2C représente une vue de dessus correspondante ; et
les figures 3A à 3D sont des vues en coupe d'une structure semiconductrice illustrant des étapes successives de formation d'un sillon profond selon le procédé de la présente invention et la figure 3E est une vue de dessus correspondante.

Dans les diverses figures, de mêmes références désignent des éléments structurels identiques ou analogues. De plus, comme cela est classique dans le domaine de la représentation des structures semiconductrices, les diverses dimensions des éléments représentés ne sont pas tracées à l'échelle mais arbitrairement dilatées pour faciliter la lisibilité des figures. Pour déterminer les valeurs effectives des diverses dimensions, l'homme de l'art se référera à ses connaissances générales et aux valeurs indiquées à titre d'exemple dans la présente description.

La figure 3A représente à titre d'exemple une portion d'un substrat 20 de type N dans lequel ont été formées, par exemple, une couche P profonde 21 et une région N⁺ 22. Un sillon doit être formé pour délimiter latéralement la jonction entre la couche P 21 et le substrat 20. Pour cela, on forme un premier masque d'oxyde de silicium 24 ayant sensiblement la forme du sillon que l'on veut graver. On notera que l'étape de gravure de la couche d'oxyde de silicium 24 aux emplacements où l'on veut former le sillon n'implique pas une étape de fabrication supplémentaire par rapport aux étapes de fabrication normales car, comme on l'a représenté, cette couche d'oxyde de silicium résulte généralement d'autres opérations de fabrication et qu'il existe souvent une étape de dégagement d'oxyde dans certaines régions, par exemple un dégagement de la surface de la région N⁺ 22. C'est au cours de la même étape que sera formée l'ouverture à l'emplacement où l'on veut graver le sillon.

Une fois la couche 24 convenablement gravée, on enlève la résine qui a servi à l'opération de photolithogravure et on dépose une nouvelle couche de résine 26 qui est ouverte à l'emplacement où l'on veut former le sillon et qui déborde vers l'intérieur de la zone où l'on veut former le sillon par rapport à l'ouverture dans le masque d'oxyde 24.

Ensuite, la structure est plongée dans un bain de gravure de silicium et, comme le représente la figure 3B, on obtient un sillon 28. En pratique, si le sillon doit avoir une profondeur de 150 micromètres et que la couche de résine déborde vers l'intérieur de la couche d'oxyde 24 d'une vingtaine de micromètres, la gravure s'étendra latéralement sous la couche de résine (environ 20 micromètres) et sous la couche d'oxyde de silicium (d'environ 80 micromètres). En conséquence, à la fin de la gravure, la partie en débordement sera essentiellement supportée par la couche d'oxyde de silicium et l'on obtient les avantages déjà présentés en relation avec les figures 2.

Une fois la gravure effectuée conformément à ce qui est représenté en figure 3B, on procède à un rinçage. Après cela, on immerge la plaquette dans un bain d'attaque chimique de l'oxyde de silicium pour obtenir une surgravure de l'oxyde de silicium dans la région désignée en figure 3C par la référence 29. Cette gravure sélective de l'oxyde de silicium est possible car, à ce stade, il existe une bonne adhérence de la couche de résine 26 sur la couche d'oxyde 24 et qu'il ne se produira pas d'infiltration du produit d'attaque entre la résine et l'oxyde. Cette bonne adhérence est liée au fait que la couche de résine 26 n'a subi que les opérations de gravure du silicium et de rinçage alors que, dans le cas de la figure 2A, elle avait subi successivement les opérations de gravure de la couche d'oxyde, de premier rinçage, de gravure du silicium et de deuxième rinçage. En outre, le fait que la résine recouvre latéralement la tranche de la couche d'oxyde contribue également à réduire les risques de pénétration.

A la suite de ces traitements, on obtient la structure illustrée en vue en coupe en figure 3D et en vue de dessus en figure 3E dans laquelle le bord 30 de la couche d'oxyde est en retrait par rapport au bord 31 du sillon. On a en outre illustré en figure 3D la présence d'un dépôt de passivation, par exemple une couche de glassivation 32. On notera que l'allure en retrait de la couche d'oxyde favorise un dépôt régulier du produit de glassivation et évite l'apparition de pointes susceptibles de créer des arcs électriques.

En outre, la structure selon la présente invention se prête facilement à une opération de ravivage qui pourra être effectuée sans risque d'apparition d'une nouvelle casquette d'oxyde.

A titre d'exemple de valeurs numériques, on notera que la profondeur de la couche P 21 peut être de l'ordre de 20 micromètres, la profondeur du sillon de l'ordre de 150 micromètres, l'épaisseur de la couche de SiO₂ thermique 24 de l'ordre du micromètre, et l'épaisseur de la couche de résine de l'ordre de 5 micromètres.

Comme produit d'attaque, on pourra choisir une iodine réfrigérée à une température de 10 à 20°C pour la gravure du sillon. La gravure de la couche d'oxyde à l'étape de la figure 3C pourra être réalisée par de l'acide fluorhydrique pur et être poursuivie jusqu'à ce que la limite 30 de la couche d'oxyde soit en retrait d'une dizaine de micromètres par rapport à la limite 31 du sillon.

La présente invention est susceptible de nombreuses variantes et modifications qui apparaîtront à l'homme de l'art, notamment en ce qui concerne les dimensions et les produits d'attaque utilisés.

Seules les étapes principales de gravure d'un sillon ont été décrites précédemment, il sera clair pour l'homme de métier qu'il devra achever le dispositif de façon classique par des opérations de prise de contact, de métallisation et d'encapsulation.

## Revendications

1. Procédé de gravure d'un sillon profond dans un substrat de silicium consistant à :
(1) délimiter à l'aide d'une première couche de résine un premier masque (24) correspondant sensiblement à la forme du sillon desiré ;
(2) enlever la première couche de résine ;
(3) déposer une nouvelle couche de résine (26) et la graver pour définir un masque de résine débordant les bords du premier masque ;
(4) immerger la plaquette dans un bain de gravure du silicium pour former le sillon désiré (28) ;
(5) rincer ;
(6) éliminer ladite nouvelle couche de résine ;
caractérisé en ce que :
(a) le premier masque est un masque d'oxyde ;
(b) à l'étape (4), la gravure est poursuivie de sorte que ledit sillon (28) s'étende partiellement sous le masque d'oxyde ;
(c) la plaquette après l'étape (5) est immergée dans un bain de gravure pour éliminer la casquette d'oxyde surplombant ledit sillon et une partie (29) de la couche d'oxyde s'étendant sur le substrat au-delà des limites du sillon.

2. Procédé de gravure selon la revendication 1, caractérisé en ce que le masque de résine (26) déborde d'environ 20 micromètres par rapport au masque d'oxyde (24).

3. Procédé de gravure selon la revendication 1, caractérisé en ce que l'étape de gravure du silicium est poursuivie jusqu'à ce que le sillon (28) ait une profondeur de l'ordre de 50 à 150 micromètres.

4. Procédé de gravure selon la revendication 1, caractérisé en ce que l'étape de gravure de l'oxyde de silicium est poursuivie jusqu'à ce que l'oxyde de silicium (24) soit en retrait du sillon (28) d'environ 10 micromètres.

## Patentansprüche

1. Verfahren zum Ätzen einer tiefen Nut bzw. Furche in einem Siliziumsubstrat, welches darin besteht, daß man:
(1) mit Hilfe einer ersten Harzschicht eine im wesentlichen der Form der gewünschten Nut entsprechende erste Maske (24) abgrenzt;
(2) die erste Harzschicht entfernt;
(3) eine neue Harzschicht (26) abscheidet und diese ätzt, um eine über die Ränder der ersten Maske überstehende bzw. diese überlappende Harzmaske zu definieren;
(4) das Plättchen in ein Silizium-Ätzbad eintaucht, um die gewünschte Nut bzw. Furche (28) zu bilden;
(5) spült;
(6) die genannte neue Harzschicht entfernt;
dadurch gekennzeichnet, daß
(a) die erste Maske eine Oxidmaske ist;
(b) im Verfahrensstadium (4) die Ätzung fortgesetzt wird, derart daß die genannte Nut bzw. Furche (28) sich teilweise unter die Oxidmaske erstreckt;
(c) das Plättchen nach dem Verfahrensstadium (5) in ein Ätzbad eingetaucht wird, um die in die Nut überhängende Oxidhaube und einen sich auf dem Substrat jenseits der Begrenzungen der Nut erstreckenden Teil (29) der Oxidschicht zu entfernen.

2. Ätzverfahren nach Anspruch 1,
dadurch gekennzeichnet, daß die Harzmaske (26) um etwa 20 µm über die Oxidmaske (24) übersteht.

3. Ätzverfahren nach Anspruch 1,
dadurch gekennzeichnet, daß das Verfahrensstadium der Siliziumätzung fortgesetzt wird, bis die Nut bzw. Furche (28) eine Tiefe in der Größenordnung von 50 bis 150 µm besitzt.

4. Ätzverfahren nach Anspruch 1,
dadurch gekennzeichnet, daß das Verfahrensstadium der Ätzung des Siliziumoxids fortgesetzt wird, bis das Siliziumoxid (24) um etwa 10 µm von der Nut (28) zurückspringt.

## Claims

1. A method for etching a deep groove in a silicon substrate consisting in:
(1) delineating through a first resist layer a first oxide mask (24) substantially corresponding to the shape of the desired groove;
(2) removing the first resist layer;
(3) depositing a new resist layer (26) and etching same to define a resist mask overlapping the edges of said first mask;
(4) immersing the wafer into a silicon etching bath to form said desired groove;
(5) rinsing;
(6) etching away said new resist layer;
characterized in that:
(a) said first mask is an oxide mask;
(b) during step (4), the etching is continued so that said groove (28) partially extends beneath said oxide mask;
(c) the plate, after step (6) is immersed into an etching bath to remove the oxide cap projecting over said groove and a portion (29) of said oxide layer formed over the substrate beyond the edges of said groove;

2. An etching method according to claim 1, characterized in that said photoresist mask (26) overlaps said oxide mask (24) by approximately 20 µm.

3. An etching method according to claim 1, characterized in that the silicon etching step is continued until said groove (28) has a depth of approximately 50-150 µm.

4. An etching method according to claim 1, characterized in that said silicon oxide etching step is continued until the silicon oxide (24) is etched back with respect to the groove by approximately 10 µm.
